# EUROPÄISCHE PATENTANMELDUNG

(11) **EP 0 548 712 A1**
(43) Veröffentlichungstag der Anmeldung: **30.06.1993**
(21) Anmeldenummer: 92121162.9
(22) Anmeldetag: 11.12.1992
(51) Int. Cl.: H03K 19/096, H03K 19/003

(54) **CMOS-Inverterstufe**

(30) Priorität: 18.12.1991 DE 4141885
(71) Anmelder: SIEMENS AKTIENGESELLSCHAFT, D-80333 München (DE)
(72) Erfinder: Scianna, Cosimo, Dott. Ing., W-8000 München 83 (DE)

(57) **Zusammenfassung**

Eine CMOS-Inverterstufe bestehend aus einer Gegentaktstufe mit komplementären Feldeffekttransistoren (5, 6) wird derart erfindungsgemäß erweitert, daß die Laststrecke eines zusätzlichen Feldeffekttransistors (4) zwischen Versorgungsspannung und dem Versorgungsspannungsanschluß der Gegentaktstufe geschaltet wird. Der Gateanschluß des zusätzlichen Feldeffekttransistors (4) ist mit dem Ausgang des CMOS-Inverters verschaltet. Die Schaltungsanordnung gewährleistet auch bei niedrigen Frequenzen ein korrektes Auswerten eines dynamischen Ausgangsknotens, welcher durch einen Precharge-Transistor (7) vorgeladen wird. Der PrechargeTransistor (7) wird durch das Ausgangssignal der Inverterstufe angesteuert. Die erfindungsgemäße Inverterstufe sperrt während der Auswertephase des Ausgangsknotens den Precharge-Transistor (7) nicht vollständig, so daß eventuelle Leckströme kompensiert werden können.

## Beschreibung

Die Erfindung betrifft eine CMOS-Inverterstufe zur Ansteuerung wenigstens eines "Precharge"-Transistors gemäß dem Oberbegriff des Anspruchs 1.

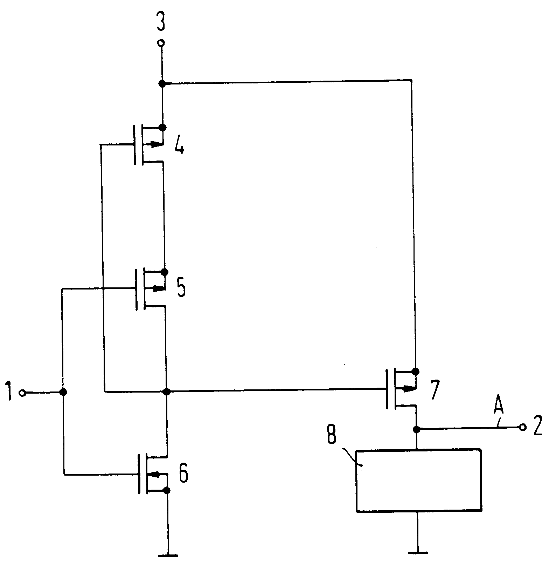

Eine derartige CMOS-Inverterstufe ist z. B. aus Tietze/Schenk Halbleiterschaltungstechnik 8. Auflage 1986 auf Seite 211 ff. beschrieben. Die Abbildung 9.36 zeigt einen derartigen CMOS-Inverter. Die Ausgangsspannung eines derartigen Inverters ist in Abhängigkeit der Eingangsspannung entweder gleich der Versorgungsspannung V_{DD} oder gleich Masse, da immer einer der beiden Transistoren T1 oder T2 leitend geschaltet ist.

Das Ausgangssignal derartiger CMOS-Inverter wird oftmals in digitalen Schaltungen dazu verwendet sogenannte Precharge-Transistoren anzusteuern. Diese "Precharge"-Transistoren dienen dazu einen Knoten auf ein bestimmtes Betriebspotential aufzuladen. Dies erfolgt während der sogenannten "Precharge"-Phase, also wenn der "Precharge"-Transistor durch das Ausgangssignal der CMOS-Inverterstufe leitend geschaltet wird. Während der sogenannten Auswertephase, also wenn der "Precharge"-Transistor durch das Ausgangssignal der CMOS-Inverterstufe gesperrt wird, wertet eine zwischen Ausgangsknoten und Masse geschaltete NMOS-Logik oder eine vergleichbare Logik diesen Abtastknoten aus. Daß heißt, der Knoten wird entweder durch die Auswerteschaltung auf Masse gezogen oder behält sein Potential bei.

In Mikroprozessoren und anderen digitalen Schaltungen werden derartige Strukturen mit meist sehr hoher Frequenz betrieben. Technologisch bedingt weisen die Ausgangsknoten die Eigenschaft auf, daß sie durch sogenannte Leckströme entladen werden. Bei hohen Betriebsfrequenzen spielt jedoch diese Fehlerquelle eine untergeordnete Rolle, da die Auswertezeiten sehr kurz sind, so daß der Ausgangsknoten in dieser Zeit nicht entladen werden kann. Bei niedrigen Betriebsfrequenzen führen aber die Leckströme dazu, daß eine fehlerhafte Auswertung des Ausgangsknotens erfolgt.

Aufgabe der Erfindung ist es daher, eine CMOS-Inverterstufe anzugeben, die einen Precharge-Transistor derart ansteuert, daß bei niedrigen Betriebsfrequenzen die Leckströme am Ausgangsknoten kompensiert werden.

Die Aufgabe wird durch die kennzeichnenden Merkmale des Anspruchs 1 gelöst.

Die Erfindung wird nachfolgend anhand einer einzigen Figur näher erläutert. Die Figur zeigt eine Ausführungsform der erfindungsgemäßen CMOS-Inverterstufe. Sie weist eine Eingangsklemme 1 auf, der z. B. das Precharge-Steuersignal zugeführt wird. Die Eingangsklemme 1 ist mit jeweils den Gateanschlüssen eines p-Kanal-FET 5 und eines n-Kanal-FET 6 verbunden. Die Laststrecken der beiden FETs 5, 6 sind in Reihe geschaltet. Der Sourceanschluß des n-Kanal-FETs 6 ist mit Masse verbunden. Der Knotenpunkt der Reihenschaltung der Laststrecken der beiden FETs 5 und 6 ist mit dem Gateanschluß des Precharge-Transistors 7, welcher vom p-Kanal-Typ ist, verschaltet. Ein weiterer p-Kanal-Transistor 4 ist vorgesehen, dessen Laststrecke zwischen einer Versorgungsspannungsklemme 3 und dem Sourceanschluß des p-Kanal-FETs 5 geschaltet ist. Der Gateanschluß des p-Kanal-FETs 4 ist mit dem Knotenpunkt der Reihenschaltung der beiden Laststrecken der FETs 5 und 6 verbunden. Weiterhin ist eine Logikanordnung 8 vorgesehen, welche zwei Anschlüsse aufweist. Der erste Anschluß der Logikanordnung 8 ist mit Masse verbunden. Der zweite Anschluß der Logikanordnung 8 ist sowohl mit dem Drainanschluß des Precharge-Transistors 7 als auch mit der Ausgangsklemme 2 verschaltet. Diese Verbindung stellt den Ausgangsknoten A dar.

Liegt an der Eingangsklemme 1 der logische Pegel "1" an, so wird der FET 6 leitend geschaltet und der FET 5 gesperrt. Der Ausgang der Inverterstufe führt dann ein Signal mit dem logischen Pegel "0". Dadurch wird sowohl der FET 4 wie auch der Precharge-Transistor 7 leitend geschaltet. Während dieser Precharge-Phase wird der Ausgangsknoten A auf das Betriebspotential, welches an der Versorgungsspannungsklemme 3 anliegt, aufgeladen.

Soll die Precharge-Phase beendet werden, so wird das Eingangssignal an der Eingangsklemme 1 auf den logischen Pegel "0" umgeschaltet. Nun sperrt der Transistor 6 und der Transistor 5 wird leitend geschaltet. Die Ausgangsspannung des Inverters steigt nun an und erreicht einen Wert welcher der Versorgungsspannung an der Klemme 3 abzüglich der effektiven Einsatzspannung des p-Kanal-Transistors 4 beträgt. Dies wiederum bewirkt, daß der Precharge-Transistor 7 nicht gänzlich gesperrt wird. Die Laststrecke des Precharge-Transistors 7 ist einerseits so hochohmig, daß der entstehende Querstrom im Falle des Entladens des Ausgangsknotens durch die Logikanordnung 8 sehr klein ist und weder auf die Verlustleistung noch auf die Schaltungsgeschwindigkeit einen nennenswerten Einfluß hat. Andererseits ist der Widerstand der Laststrecke des Precharge-Transistors 7 niedrig genug um einen Kompensationsstrom zu erzeugen, welcher die Leckströme des Ausgangsknotens A kompensiert.

Die erfindungsgemäße Inverterstufe läßt sich in allen digitalen Schaltungen, die auch mit niedriger Frequenz betrieben werden, einfach realisieren. Die Dimensionierung der FETs insbesondere des p-Kanal-FET 4 spielt dabei eine untergeordnete Rolle.

Selbstverständlich ist auch eine Anordnung mit Transistoren vom komplementären Typ möglich.

## Patentansprüche

1. CMOS-Inverterstufe zur Ansteuerung wenigstens eines Precharge-Transistors (7) mit einem ersten Feldeffekttransistor (5) von einem ersten Leistungstyp und einem zweiten Feldeffekttransistor (6) von einem zweiten Leistungstyp, deren Laststrecken in Reihe geschaltet sind und deren Gateanschlüsse miteinander verbunden sind, den Gateanschlüssen ein Eingangssignal zugeführt wird und am Knotenpunkt der Reihenschaltung der Laststrecken das Ausgangssignal abgreifbar ist, welches dem Precharge-Transistor (7) zugeführt wird, der Sourceanschluß des zweiten Feldeffekttransistors (6) mit einem ersten Betriebspotentialanschluß verbunden ist,
**dadurch gekennzeichnet,** daß ein dritter Feldeffekttransistor (4) vom ersten Leitungstyp vorgesehen ist, dessen Laststrecke in Reihe zwischen einem zweiten Betriebspotentialanschluß und der Reihenschaltung der beiden Laststrecken des ersten und zweiten Feldeffekttransistors (5, 6) geschaltet ist und der Gateanschluß des dritten Feldeffekttransistors (4) mit dem Knotenpunkt der Reihenschaltung der Laststrecken des ersten und zweiten Feldeffekttransistors (5, 6) verschaltet ist.
